# EUROPEAN PATENT APPLICATION

(11) **EP 1 320 127 A2**
(43) Date of publication of application: **18.06.2003**
(21) Application number: 02102745.3
(22) Date of filing: 12.12.2002
(51) Int. Cl.: H01L 21/314

(54) **Oxynitride device and method using non-stoichiometric silicon oxide**

(30) Priority: 12.12.2001 US 339639; 31.01.2002 US 61637
(71) Applicant: Texas Instruments Incorporated, Dallas, Texas 75251 (US)
(72) Inventor: Colombo, Luigi, 75248, Dallas (US); Khamankar, Rajesh, 75019, Copell (US); Rotondaro, Antonio, 75206, Dallas (US)
(74) Representative: Holt, Michael

(57) **Abstract**

A method (20) of forming a semiconductor device (30). The method provides a semiconductor substrate (32), and the method forms (22) a non-stoichiometric silicon oxide layer (34) in a fixed relationship relative to the semiconductor substrate. A majority (34a) of the non-stoichiometric silicon oxide layer comprises Si_{*z*}O_{*y*} and the ratio of *y*/*z* is less than two. The method also performs (24) a nitridation of the non-stoichiometric silicon oxide layer.

## Description

The present embodiments relate to semiconductor devices and methods and are more particularly directed to oxynitride devices and methods.

Semiconductor devices are prevalent in countless different aspects of contemporary society, and as a result, the marketplace for such devices continues to advance at a fairly rapid pace. This advancement is evident in many respects and relates to semiconductor devices either directly or indirectly as well as the methods for forming such devices. For example, the advancement affects numerous attributes of semiconductor devices, including reduced device size and improved device reliability. These aspects as well as others are addressed by the prior art and are further improved upon by the preferred embodiments as detailed below.

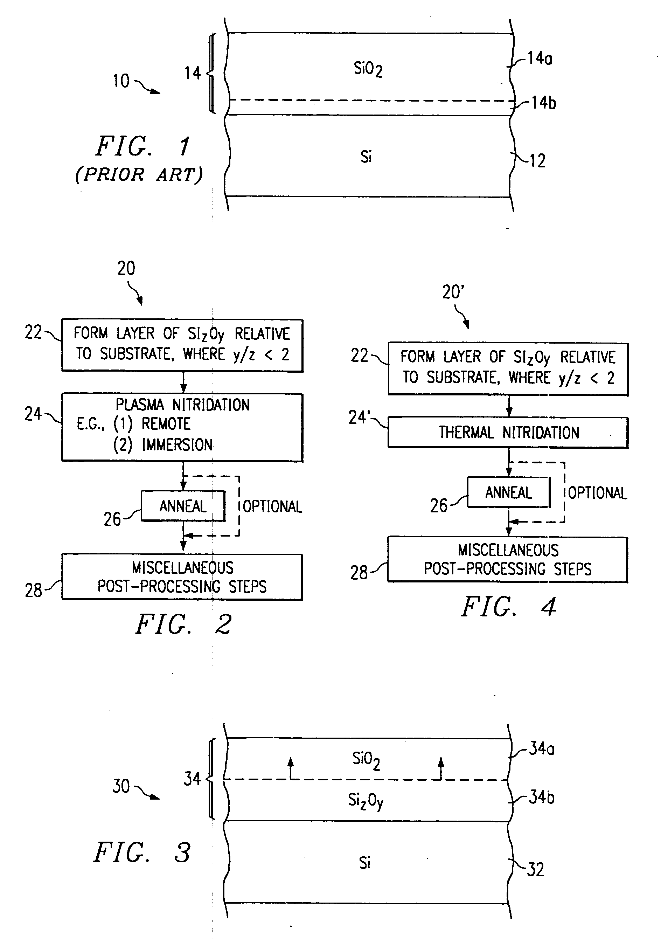

By way of further background, the preferred embodiments relate to oxynitride layers in semiconductor devices. Oxynitride layers are particularly attractive in various devices because they provide a larger dielectric constant as compared to silicon dioxide layers. As further introduction to the preferred embodiments and also to facilitate a discussion of the prior art, an example of an oxynitride layer is presented in connection with Figure 1. Specifically, Figure 1, which is not drawn to scale for sake of simplification, illustrates a cross-section of a semiconductor device 10 that includes a semiconductor substrate 12, and in the present example substrate 12 is silicon. A generally silicon dioxide (SiO₂) layer 14 is formed over substrate 12, as may be achieved in various manners such as exposing substrate 12 to an oxidizing ambient. In contemporary devices, layer 14 may be on the order of 20 Angstroms thick. Using contemporary processes, however, note that layer 14 results in what may be described as two separate sub-layers due to the material composition in each of those sub-layers as they form layer 14, and these sub-layers are illustrated apart from one another using a horizontal dashed line in Figure 1. Also given the existence of sub-layers, note at this point that layer 14 is identified as only "generally" silicon dioxide. In actuality, at the top of the layered device is a silicon dioxide sub-layer 14a, whereas between sub-layer 14a and substrate 12 is a sub-layer 14b that is commonly referred to as a sub-oxide layer or sometimes as a sub-oxide transitional layer. The latter terminology reflects the notion that sub-layer 14b is a transition between the more desirable silicon dioxide attributes of sub-layer 14a and the silicon composition of substrate 12. Lastly, for the stated example where sub-layer 14a is 20 Angstroms thick, note that sub-layer 14b is much thinner than sub-layer 14a and indeed sub-layer 14b may be on the order of 3 to 6 Angstroms thick (i.e., one or two monolayers).

Further with respect to Figure 1, note that the actual location of the dashed line, that is the physical demarcation between sub-layers 14a and 14b, is not subject to precise location. Generally, the theoretical location of the line may be identified with respect to the quality of the materials in layer 14. Specifically, it is accepted in the art that for sub-layer 14a, which defines the area existing above the dashed line, it consists of silicon dioxide having a sufficiently good quality, such as may be identified by way of example by measuring the interface trap density (Dᵢₜ) of the material in the sub-layer. For example, silicon dioxide sub-layer 14a is commonly defined to exist where the measured Dᵢₜ is less than or equal to 10¹⁰/cm². With such a Dᵢₜ value, silicon dioxide sub-layer 14a is anticipated to provide acceptable electrical attributes as a silicon dioxide material. In contrast, the attributes of sub-oxide sub-layer 14b, which defines the area below the dashed line, are considered to be unacceptable in the sense of operating according to expected electrical attributes for silicon dioxide. Indeed, for this reason as well as others described later, the current state of the art often endeavors to form silicon dioxide sub-layer 14a to be as pure as possible and in relation seeks to minimize the thickness of sub-oxide sub-layer 14b. Accordingly, it is the goal of the prior art to form the purest possible silicon dioxide, SiO₂, in sub-layer 14a and to provide its thickness such that it forms the majority of generally silicon dioxide layer 14.

Semiconductor device 10 may be formed for various purposes, but one very prevalent example is its use in connection with a transistor. In such a case, substrate 12 (or a region in it) provides the transistor channel and possible related regions, while ultimately generally silicon dioxide layer 14 provides the transistor gate insulator. As to the latter, therefore, a gate structure (e.g., polysilicon) is later formed over silicon dioxide layer 14 so that an electrical bias as applied to that gate structure may induce a controlled electrical conduction path through the transistor channel. In this regard as well as in other devices, the art sometimes strives to increase the dielectric constant of layer 14. To achieve this goal, nitrogen is introduced to layer 14 in an effort to convert the layer into oxynitride (SiON). Over the years, nitrogen has been introduced in a number of ways. As a first example, nitrogen may be introduced during growth at relatively high temperatures (e.g., > 900 °C). As a second example, remote plasma nitridation may be supplied to the silicon dioxide. While both of these prior art approaches have increased the dielectric constant of layer 14 to some extent, the present inventors have observed various drawbacks of such approaches. As an example of a drawback with respect to the first-described prior art nitridation approach, it has been observed that the resultant nitrogen concentration is largely within sub-oxide sub-layer 14b, whereas for an improved device it is desired to have the nitrogen more uniformly existing in layer 14 as a whole. As an example of a drawback with respect to the second-described prior art nitridation approach, the amount of nitrogen distributed within layer 14 is highly dependent on the energy used to impart the nitrogen in that layer. Thus, the urge is to increase that energy, but such an approach yields various drawbacks. As one example of a drawback from increased energy, this approach has resulted in a device where the nitrogen is found within substrate 12 which clearly is undesirable for various reasons, particularly when nitrogen penetrates the region intended to be the transistor channel. In this case, the nitrogen that reaches substrate 12 will degrade mobility, thereby adversely affecting the current drive of the transistor. As another example of a drawback from increased nitridation energy, the relatively large energy renders the device more susceptible to damage from later processing steps.

In view of the above, the present inventors provide below various alternative embodiments having an oxynitride layer with an attendant relatively large dielectric constant while improving upon various drawbacks of the prior art.

### BRIEF SUMMARY OF THE INVENTION

In one preferred embodiment, there is a method of forming a semiconductor device. The method provides a semiconductor substrate, and the method forms a non-stoichiometric silicon oxide layer in a fixed relationship relative to the semiconductor substrate. A majority of the non-stoichiometric silicon oxide layer comprises Si_{*z*}O_{*y*} and the ratio of y/z is less than two. The method also performs a nitridation of the non-stoichiometric silicon oxide layer. Other aspects are also disclosed and claimed.

### BRIEF DESCRIPTION OF THE SEVERAL VIEWS OF THE DRAWING

Figure 1 illustrates a cross-sectional view of a portion of a prior art semiconductor device having a silicon dioxide layer from which an oxynitride layer is formed.

Figure 2 illustrates a flow chart of one preferred embodiment for forming a layer of non-stoichiometric silicon oxide, Si_{*z*}O_{*y*}, and thereafter subjecting the non-stoichiometric silicon oxide to a nitride plasma to form a high dielectric constant layer.

Figure 3 illustrates a cross-sectional view of a portion of a semiconductor device according to the preferred embodiment and having a layer of Si_{*z*}O_{*y*} from which an oxynitride layer is formed.

Figure 4 illustrates a flow chart of another preferred embodiment for forming a layer of non-stoichiometric silicon oxide, Si_{*z*}O_{*y*}, and thereafter subjecting the non-stoichiometric silicon oxide to a thermal nitride to form a high dielectric constant layer.

### DETAILED DESCRIPTION OF THE INVENTION

Figure 1 was discussed in the earlier Background Of The Invention section of this document and in connection with the prior art and the reader is assumed familiar with the principles of that discussion.

Figure 2 illustrates a flow chart of a method designated generally at 20 and for forming an improved oxynitride device such as is shown in Figure 3 and represented generally at 30. Method 20 is now described with additional reference to Figure 3 for further illustration of the inventive scope.

Method 20 commences with a step 22 where a layer 34 of material is formed overlying silicon substrate 32, or alternatively in some other fixed relationship relative to silicon substrate 32. Layer 34 has an atomic make-up that may be represented as Si_{*z*}O_{*y*}, where the values *z* and *y* are described below. For sake of comparison to the earlier described prior art device of Figure 1, assume that layer 34 is also 20 Angstroms thick. In the preferred embodiment, the values *z* and *y* provide a basis to demonstrate that the layer of step 22 is not SiO₂, that is, if *z* equals one then in the preferred embodiment y does not equal two. Instead, in the preferred embodiment, the Si_{*z*}O_{*y*} is silicon-rich as compared to SiO₂, that is, preferably the ratio of *y*/*z* is less than two. As a result, by measuring the electrical attributes of layer 34, it contains excess silicon, relative to oxygen, as compared to contemporary commercially used gate oxide silicon dioxides. Thus, on average throughout layer 34, for certain molecules having an individual silicon atom, they have only one bonded oxygen atom rather than two atoms as is the case for SiO₂. Of course, in the prior art commercial devices with a silicon dioxide layer such as sub-layer 14a of Figure 1, it is not expected for the prior art sub-layer 14a that every molecule is perfect in having two oxygen atoms per every silicon atom. However, on average throughout the prior art sub-layer 14a it is considered relatively close to such an ideal case when its Dᵢₜ, as introduced above, is less than or equal to 10¹⁰/cm². Moreover, for the prior art case, its silicon dioxide is what is commonly defined as stoichiometric because its Dᵢₜ measures at this relatively low level. In contrast, in step 22, the preferred embodiment purposefully creates a layer 34 wherein *y* and *z* of Si_{*z*}O_{*y*} are established to create what would be termed non-stoichiometric silicon oxide by one skilled in the art because its Dᵢₜ should be in excess of the stoichiometric level for silicon dioxide (e.g., of 10¹⁰/cm²). For example, preferably for a value of *z*=1 then on average *y*<2 and the Dᵢₜ for the step 22 layer is much higher than 10¹¹/cm² or greater. Lastly, note that given the specified preferred values for *z* and *y* in Si_{*z*}O_{*y*}, one skilled in the art may ascertain various techniques for forming such a layer (e.g., growing the layer on substrate 32 using appropriate conditions).

With additional reference to Figure 3, note that the layer formed by step 22 may be considering as having two sub-layers 34a and 34b in the sense of material composition, as illustrated with a horizontal dashed line between those sub-layers. Sub-layer 34a is considerably thicker than sub-layer 34b, that is, in terms of thickness sub-layer 34a forms the majority of layer 34. Additionally, sub-layer 34b separates sub-layer 34a from silicon substrate 32. Like the prior art device of Figure 1 where layer 34 is 20 Angstroms thick, then in contrast for the preferred embodiment sub-layer 34b is on the order of 10 to 12 Angstroms thick. Additionally, note that sub-layer 34a will reflect the non-stoichiometric nature of sub-layer 34b, but sub-layer 34a has an even greater excess of silicon relative to oxygen than does sub-layer 34b. In other words, if sub-layer 34a is represented as Si_{*z*}O_{*y*}, then in sub-layer 34b its oxygen concentration will be less than the y. In any event, by way of comparison to the prior art it is noted that layer 34 is preferably non-stoichiometric, as that term has been defined herein, throughout the majority if not the entirety of the layer whereas the prior art implements stoichiometric silicon dioxide in the majority of its layer 14; further, in the preferred embodiment, the degree of its non-stoichiometry may vary toward the interface of layer 34 with silicon substrate 32.

Returning to Figure 2, after step 22 method 20 continues to step 24. In step 24, a plasma nitridation is performed on the device illustrated in Figure 3. In the preferred embodiment, the goal of step 24 is to incorporate the nitrogen into non-stoichiometric layer 34 as uniformly as possible and with little or no nitrogen reaching substrate 32. Two preferred alternatives are contemplated for the nitride plasma. As a first alternative, a plasma nitridation is performed which is so named in that the plasma is formed in an area deemed remote from the semiconductor wafer on which device 30 (and typically numerous comparable devices) is formed. Plasma nitridation is generally known in the art, but for specific details of one approach the reader is invited to read U.S. Patent 6,136,654, entitled "Method of forming thin silicon nitride or silicon oxynitride gate dielectrics," filed December 4, 1997, and issued October 24, 2000, which is hereby incorporated herein by reference. As a second alternative, an immersion plasma nitridation is performed which is so named in that the plasma is formed in the same chamber that houses the wafer on which device 30 is formed. For either alternative, preferably N₂ is provided in the plasma as the nitrogen source, and it may be accompanied by one or more other inert gases (e.g., He, Ar).

After step 24, method 20 continues to step 26. In step 26, device 30 is annealed. The anneal step is preferred because it tends to advance the equilibrium of the atoms in the layers created and processed as described above. The anneal step may be in either an inert or oxidizing environment, where an inert ambient may be provided by ways of example with He, Ar, or N and where an oxidizing ambient may be one of various mixtures including oxygen. In addition, the anneal may be performed under various conditions. For example, temperatures may be in a range of 600 °C to 1100 °C, pressure may be in a range of 1 milliTorr to 1 atmosphere, and time may be in a range of 1 second to 10 minutes. Lastly, note that in some implementations, anneal step 26 may be eliminated although in most instances following the plasma nitridation it is preferable.

After step 26, method 20 continues to step 28 which generally indicates additional post-processing steps. These steps may be ascertained by one skilled in the art according to various criteria relating to the specific device in which the above-described layers are used as well as the implementation of that device. For example, if the device of Figure 3 is to be used as a transistor gate insulator, then other known transistor fabrication steps are taken. For example, a gate conductive layer (e.g., polysilicon) is formed over the oxynitride and etched to form a gate stack. Either before or after the formation of the gate stack, additional implants are formed in substrate 32 such as to form the transistor source and drain, and still others related regions and connections may be formed.

Figure 4 illustrates a flow chart of an alternative method designated generally at 20' and also for forming an improved oxynitride device such as device 30 in Figure 3. Method 20' shares some of the same steps with method 20 described above in connection with Figure 2 and uses the same reference numbers for such steps. Additionally, the reader is assumed familiar with the earlier discussion so various details are not re-stated with respect to method 20'. For example, method 20' also beings with step 22, where recall from above that layer 34 is formed and has an atomic make-up of Si_{*z*}O_{*y*}, that is, a non-stoichiometric silicon oxide layer is formed where the ratio of *y*/*z* is less than two. Thereafter, method 20' continues to step 24', which is described below.

In step 24', a thermal nitridation is performed on the device illustrated in Figure 3. As with step 24 described above, the goal of step 24' is to incorporate the nitrogen into non-stoichiometric layer 34 as uniformly as possible and with little or no nitrogen reaching substrate 32. The thermal nitridation may be performed using different processes, such as by way of example using either a rapid thermal process or a furnace. For either alternative, preferably it includes a primary source of nitrogen, where preferably such a source is one of NH₃, NO, or N₂O. In addition, the primary source of nitrogen may be combined with a diluent. Preferred alternatives for the diluent include N₂, He, and Ar. Based on various criteria, one skilled in the art may select an appropriate range for each of time, temperature, and pressure. For example, 60 minutes at 1000 °C in 1 atm of NH₃.

Following step 24', method 20' may continue to step 26; however, in Figure 4 this process flow is shown with a dashed line that also connects directly to step 28. This use of a dashed line is intended to depict that the anneal of step 26 may be less desirable than in the case of the plasma nitridation step 24 of method 20 in Figure 2. Thus, in the alternative provided by method 20', one skilled in the art may choose to include or bypass step 26. In any event, method 20' then concludes with step 28, which performs various post-processing steps as described earlier in connection with Figure 2.

From the above, it may be appreciated that either method 20 or method 20' provides for the formation of a non-stoichiometric silicon oxide layer and its formation in a fixed relationship relative to a semiconductor substrate. The non-stoichiometric silicon oxide layer is subsequently treated with nitrogen to form an oxynitride, and the result provides numerous benefits. For example, after the nitrogen treatment, the resulting material overlying the semiconductor substrate will have a more uniform concentration of nitrogen above the semiconductor substrate a larger dielectric constant as compared to silicon dioxide. Such a higher dielectric constant material also leads to benefits in the device that is then formed using the high-dielectric constant material. As another benefit, various of the above processes can be achieved using lower energy treatments as compared to the prior art formation of oxynitrides. As a result, device reliability is improved as is the resistance to problems from additional post-anneal processes. As yet another benefit, greater accuracy in scaling may be achieved as opposed to prior art formation of oxynitrides. Still further, the preferred embodiments impart little or no nitrogen into the semiconductor substrate as opposed to certain prior art approaches where nitrogen reaches the semiconductor substrate. Lastly, many of these benefits may become even more pronounced as transistor sizes are reduced and the gate insulator, which may be formed according to the preferred embodiments, becomes a larger percentage in size of the overall device. The preceding benefits as well as the various alternative steps described above thus demonstrate the flexibility of the inventive scope, and they should also demonstrate that while the present embodiments have been described in detail, various substitutions, modifications or alterations could be made to the descriptions set forth above without departing from the inventive scope which is defined by the following claims.

## Claims

**1.** A method of forming a semiconductor device, comprising:
providing a semiconductor substrate;
forming a non-stoichiometric silicon oxide layer in a fixed relationship relative to the semiconductor substrate, wherein a majority of the non-stoichiometric silicon oxide layer comprises Si_{*z*}O_{*y*} and wherein a ratio of *y*/*z* is less than two; and
performing a nitridation of the non-stoichiometric silicon oxide layer.

**2.** The method of claim 1 wherein the forming step comprising forming a non-stoichiometric silicon oxide layer having an interface trap density greater than or equal to 10¹¹/cm².

**3.** The method of claim 1 or claim 2 wherein the step of performing a nitridation comprises performing a plasma nitridation.

**4.** The method of claim 3 wherein the step of performing a plasma nitridation comprises exposing the non-stoichiometric silicon oxide layer to a remote plasma nitridation.

**5.** The method of claim 3 wherein the step of performing a plasma nitridation comprises exposing the non-stoichiometric silicon oxide layer to an immersion nitridation plasma.6. The method of any preceding claim and further comprising, after the step of performing a nitridation of the non-stoichiometric silicon oxide layer, annealing the semiconductor device.

**7.** The method of any preceding claim wherein the step of performing a nitridation forms a nitridized non-stoichiometric silicon oxide layer, and further comprising forming a gate conductor in a fixed position relative to the nitridized non-stoichiometric silicon oxide layer.

**8.** The method of claim 7 and further comprising forming a source region and a drain region in a fixed position relative to the nitridized non-stoichiometric silicon oxide layer.

**9.** The method of any preceding claim wherein the step of performing a nitridation of the non-stoichiometric silicon oxide layer comprises heating the substrate in an atmosphere that contains a nitrogen source selected from the group consisting of NH₃, NO, or N₂O.
